Europäisches Patentamt

European Patent Office

Office européen des brevets

(11) Numéro de publication : **0 387 949 B1**

(19)

(12) # FASCICULE DE BREVET EUROPEEN

(45) Date de publication du fascicule du brevet :
**14.12.94 Bulletin 94/50**

(51) Int. Cl.$^5$ : **H03H 11/52, H01P 1/38**

(21) Numéro de dépôt : **90200549.5**

(22) Date de dépôt : **08.03.90**

(54) **Dispositif semiconducteur intégré incluant un circuit isolateur actif.**

(30) Priorité : **14.03.89 FR 8903308**

(43) Date de publication de la demande :
**19.09.90 Bulletin 90/38**

(45) Mention de la délivrance du brevet :
**14.12.94 Bulletin 94/50**

(84) Etats contractants désignés :
**DE FR GB IT NL**

(56) Documents cités :
**EP-A- 0 282 293**
**1988 IEEE MTT INTERNATIONAL MICRO-
WAVE SYMPOSIUM DIGEST , New York, 25-27
mai 1988, vol.2,pages 1015-1016, IEEE, New
York, us; M.A. SMITH: "GaAs monolithic
implementation of active circulators"**

(73) Titulaire : **LABORATOIRES D'ELECTRONIQUE
PHILIPS**
**3, Avenue Descartes**
**F-94450 Limeil-Brévannes (FR)**
(84) **FR**
Titulaire : **N.V. Philips' Gloeilampenfabrieken**
**Groenewoudseweg 1**
**NL-5621 BA Eindhoven (NL)**
(84) **DE GB IT NL**

(72) Inventeur : **Pyndiah, Ramesh, Société Civile
S.P.I.D.**
**209 rue de L'Université**
**F-75007 Paris (FR)**
Inventeur : **Van den Bogaart,Francis, Société
Civile S.P.I.D.**
**209 rue de L'Université**
**F-75007 Paris (FR)**

(74) Mandataire : **Landousy, Christian et al
Société Civile S.P.I.D.**
**156, Boulevard Haussmann**
**F-75008 Paris (FR)**

## Description

L'invention concerne un dispositif semiconducteur intégré incluant un circuit isolateur actif comprenant au moins un transistor à effet de champ.

L'invention trouve son application dans la réalisation de systèmes hyperfréquences tels qu'une tête de réception d'antenne pour satellite artificiel, dans laquelle il est nécessaire d'isoler l'oscillateur local des variations d'impédance du mélangeur. L'invention trouve aussi son application dans la réalisation de circulateurs hyperfréquences.

Un circuit isolateur est connu du brevet US n°4,679,010, juillet 1987, ainsi que par la publication intitulée : "The design of a 6-Port active circulator" par I.J. BAHL dans 1988 IEEE, MTT-S Digest" pages 1011-1014. Ces documents décrivent un circuit circulateur actif constitué de trois circuits isolateurs et de trois coupleurs.

Notamment la plublication enseigne que dans de nombreux circuits hyperfréquences, des composants non réciproques tels que des isolateurs ou des circulateurs sont utiles pour éviter des interactions entre les différents blocs du système. Dans les sytèmes hyperfréquences conventionnels on utilisait la ferrite pour réaliser de tels composants. Aujourd'hui ces composants peuvent être réalisés sur des substrats en GaAs en ajoutant des disques de ferrite et des aimants permanents. Cependant cette technique résulte en une très grande taille et un poids important des composants et n'est pas compatible avec la technologie des circuits intégrés monolithiques hyperfréquences. C'est pourquoi le brevet et la publication citée proposent un circulateur actif entièrement intégrable. A cet effet, dans la publication citée les circuits isolateurs nécessaires à la réalisation du circulateur sont constitués d'amplificateurs monolithiques distribués à quatre cellules fonctionnant entre 1 à 10 GHz avec un gain de 7 dB, des pertes par retour et une isolation meilleure que 12 dB et 20 dB respectivement. Cet amplificateur utilise 4 transistors à effet de champ, de grille 0,5 x 150 μm et consomme environ 60 mw. Une description complète de ces circuits isolateurs peut être trouvée dans la publication intitulée : "A monolithic GaAs 1-13 GHz Travelling-Wave Amplifier" dans IEEE TRANSACTION ON MICROWAVE THEORY AND TECHNIQUES, Vol.MTT-30, No.7, July 1982 par YALCIN AYASLI et al.

Ce circuit isolateur connu présente plusieurs inconvénients :
- l'adaptation de 12 dB et l'isolation de 20 dB réalisées par ce circuit ne sont pas suffisantes pour l'application envisagée citée plus haut ;
l'utilisation de 4 transistors pour former ce circuit entraine une consommation importante de 60 mw ;
- la surface occupée est grande (2 mm²) ce qui présente un inconvénient pour l'application aux circuits intégrés ;
- les performances sont sensibles aux paramètres technologiques.

Au contraire dans le brevet cité, le circuit isolateur est différent.

Dans le brevet cité, le circuit isolateur contient un FET monté en grille commune, à l'entrée, et un FET monté en drain commun, à la sortie. La dimension des FETs est optimisée pour obtenir une bonne adaptation à 50 Ω.

Le circuit connu de ce brevet contient en outre des circuits L-C série, reliés entre la ligne de transmission et la masse dont la fonction est d'équilibrer le circuit. Le premier transistor fonctionne comme un amplificateur dimensionné pour les hautes fréquences. Le circuit est prévu pour bloquer les basses fréquences dans toutes les directions.

Ce brevet cité enseigne que le second transistor présente une impédance grille-source si élevée qu'un signal réfléchi entrant par la sortie et se propageant dans la direction opposée en sens entrée-sortie, a une atténuation de 25 dB.

En réalité l'homme du métier sait que la capacité grille-source d'un transistor est 10 fois plus faible environ, que sa capacité grille-drain. Les performances annoncées dans ce brevet cité semblent donc tout à fait surévaluées.

Une autre publication intitulée "Active isolator-combiner divider and magic-T as miniaturize function bloc" par TSUNEO TOKUMITSU dans GaAs IC Symposium IEEE 1988 p.273 à 276 décrit le même circuit isolateur.

Cette publication enseigne que l'isolation n'est que de 20 dB à 10 GHz avec une adapation en entrée à la même fréquence, de 15 dB.

Ces performances sont insuffisantes pour les applications envisagées à la présente invention.

D'autre part, les circuits isolateurs connus du brevet et de la dernière des publications citées comportent 4 selfs qui sont des éléments nécessitant chacun une grande surface dans un circuit, et qui doivent donc être évités autant que possible pour les applications aux circuits intégrés.

La présente invention a pour but de proposer un circuit isolateur actif permettant d'obtenir une meilleure adaptation ainsi qu'une meilleure isolation que les circuits connus, sur une large bande de fréquences, et ceci au moyen d'un circuit très simple, compact, peu sensible aux paramètres technologiques et de faible consommation.

Ces buts sont atteints au moyen d'un dispositif tel que décrit dans le préambule, en outre caractérisé en ce que le circuit isolateur comprend un circuit amplificateur à contre-réaction utilisé dans le sens inverse du sens conventionnel.

Dans ces conditions, le circuit selon l'invention peut être beaucoup plus simple que l'amplificateur distribué connu de la publication et du brevet cités.

Dans une mise en oeuvre, le dispositif selon l'invention est caractérisé en ce que cet amplificateur comprend un étage incluant un transistor à effet de champ, monté en source commune, dont le drain reçoit le signal d'entrée $V_E$, et dont la grille fournit le signal de sortie $V_S$ et un circuit de contre-réaction disposé entre la grille et le drain.

Le dispositif selon l'invention présente ainsi l'avantage de pouvoir être réalisé dans toute technologie au moyen de transistors à effet de champ par exemple dans les technologies mettant en oeuvre les composés III-V ou encore le silicium.

Dans les technologies mettant en oeuvre les composés III-V, les fréquences de fonctionnement atteintes peuvent être extrêmement élevées.

L'invention sera mieux comprise au moyen de la description suivante illustrée par les figures annexées dont :

- la figure 1a qui représente schématiquement le circuit isolateur selon l'invention ;
- la figure 1b qui représente le schéma équivalent du circuit de la figure 1a ;
- la figure 2 qui représente schématiquement le circuit isolateur dans une mise en oeuvre au moyen de transistors à effet de champ en arséniure de gallium ;
- les figures 3a et 3b qui représentent, en fonction de la fréquence, les paramètres S21, S12, S22 et S11 en dB du circuit selon l'invention pour un temps de transit des électrons sous la grille de 2,8 ps ;
- les figures 4a et 4b qui représentent ces mêmes paramètres pour un temps de transit de 3,5 ps ;
- et les figures 5a et 5b qui représentent ces mêmes paramètres pour un temps de transit de 2,1 ps.

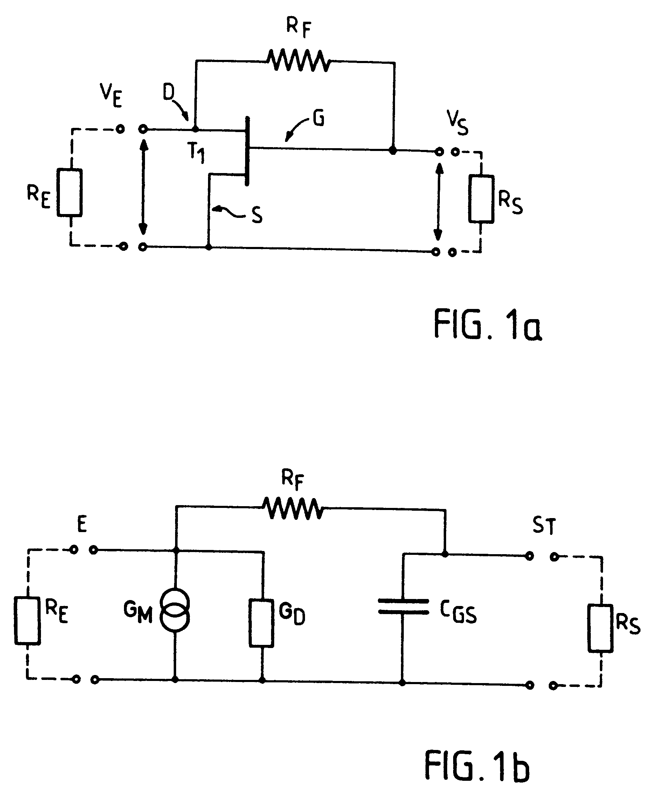

Tel que représenté sur la figure 1a, le circuit isolateur selon l'invention comprend un transistor à effet de champ $T_1$, de source S, de grille G et de drain D. Pour réaliser un circuit isolateur, ce transistor à effet de champ est monté en amplificateur à contre-réaction utilisé dans le sens inverse du sens conventionnel.

A cet effet, une branche de contre-réaction incluant une résistance $R_F$ est disposée entre sa grille et son drain. Le signal d'entrée $V_E$ est appliqué entre sa source et son drain et le signal de sortie $V_S$ est prélevé entre sa source et sa grille. L'impédance de sortie du circuit précédent est symbolisée par la résistance $R_E$ disposée entre le drain et la source du transistor $T_1$. L'impédance d'entrée du circuit suivant est symbolisée par la résistance $R_S$ disposée entre la grille et la source du transistor $T_1$. La conductance de la contre-réaction est alors $g_F = 1/R_F$ ; la conductance d'entrée est alors $g_E = 1/R_E$ ; et la conductance de sortie $g_S = 1/R_S$.

Le circuit de la figure 1b est le schéma équivalent au circuit de la figure 1a. $g_m$ représente la transconductance du transistor $T_1$, $g_D$ représente sa conductance de drain, $R_F$ est encore la résistance de la branche de contre-réaction et $C_{GS}$ est la capacité grille-source du transistor $T_1$.

Dans ces conditions, le gain du circuit isolateur selon l'invention est donné par la relation (1) du tableau I. La conductance d'entrée de cet isolateur est $Y_E$ donnée par la relation (2). Dans ces relations $\omega$ est la pulsation du signal $V_E$ de fréquence F appliqué à l'entrée de l'étage isolateur.

Dans le tableau I, l'isolation représentée par le rapport de la tension d'entrée sur la tension de sortie est donnée par la relation (3) ; la conductance de sortie de l'isolateur est $Y_S$ donnée par la relation (4).

Dans la relation (4) le terme $j\omega C_{GS}$ est une petite susceptance qui augmente avec la fréquence et qui peut apporter des limitations aux très hautes fréquences.

Selon l'invention, on impose que la conductance de la contre-réaction $g_F$ soit égale à la transconductance $g_M$ du transistor $T_1$. Dans ces conditions, le terme donnant l'isolation devient nul ce qui signifie que le gain de l'étage en inverse est nul.

On veut d'autre part que le circuit isolateur selon l'invention consiste en une adaptation des circuits précédents et des circuits suivants à une impédance de référence donnée $R_0$. Pour obtenir ce résultat, les caractéristiques du transistor à effet de champ $T_1$ sont choisies pour que la somme de sa transconductance $g_M$ et de sa conductance de drain $g_D$ soit égale à l'inverse de l'impédance $R_0$ donnée.

Ces conditions sont rappelées par les relations (5) et les relations (6) du tableau III.

Il en résulte que l'impédance d'entrée du circuit isolateur selon l'invention s'exprime alors par la relation (7) et son impédance de sortie par la relation (8) du tableau III.

Si l'on choisit l'impédance de référence $R_0$ égale à 50 $\Omega$ alors le gain de l'isolateur $V_S/V_E$ est équivalent à 1/2 (relation 1bis du tableau III), et l'isolation $V_E/V_S$ est égale à 0 (relation 3bis du tableau III).

Dans une forme de réalisation, la branche de contre-réaction peut comprendre seulement une résistance $R_F$ disposée entre la grille et le drain du transistor $T_1$. Dans le cas où on choisit l'impédance de référence $R_0$ égale à 50 $\Omega$ il faut alors choisir la taille du transistor pour que $g_M + g_D = 20$ mS.

Dans ces conditions la conductance d'entrée $Y_E$ = 20 mS, et la conductance de sortie égale 20 mS, plus une petite susceptance citée plus haut.

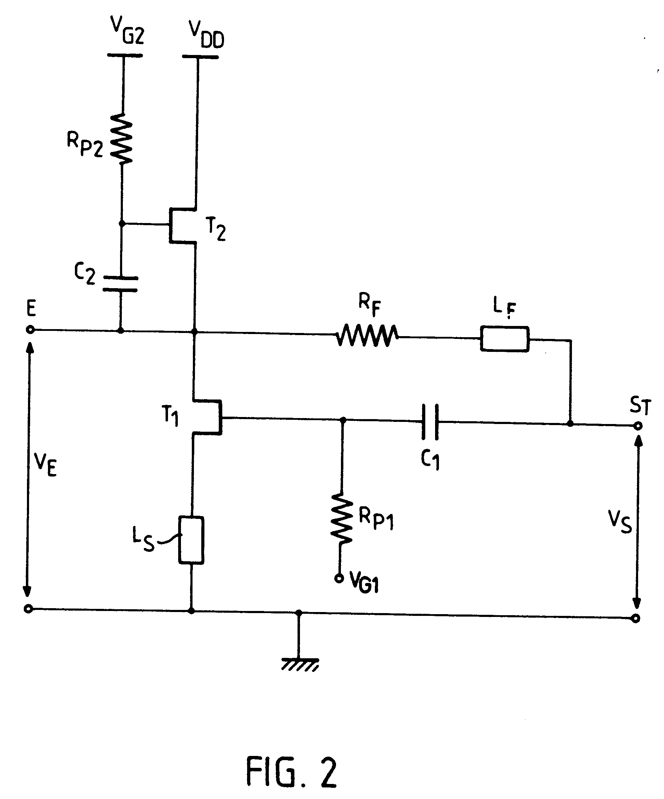

Tel que représenté sur la figure 2, le circuit isolateur selon l'invention est une mise en oeuvre particulièrement appropriée à être utilisée aux fréquences élevées. A ces fréquences élevées, il apparaît des retards dus au temps de transit des électrons sous la grille du transistor $T_1$ et aux constantes de temps produites par les résistances d'accès et les résistances intrinsèques du transistor ainsi qu'à la capacité grille-source. Pour compenser ces retards aux fréquences élevées, la branche de contre-réaction peut comprendre aussi une ligne $L_F$ disposée en série avec la résistance $R_F$. Cette ligne sera favorablement une ligne microruban. Dans la forme de réalisation du circuit selon l'invention illustrée par la figure 2, pour rendre ajustable la valeur de la transconductance $g_M$ du transistor $T_1$ et pour compenser les effets des dispersions de ses caractéristiques dues à la technologie, la grille du transistor $T_1$ est munie de moyens de polarisation. Ces moyens de polarisation comprennent une tension de polarisation continue négative $V_{G1}$ appliquée sur la grille à travers une résistance $R_{P1}$.

D'autre part, lors de la mise en oeuvre du circuit selon l'invention illustrée sur la figure 2, on a constaté qu'il était avantageux pour améliorer les performances du circuit de munir le transistor $T_1$ d'une charge active. A cet effet, un transistor $T_2$ est disposé entre une tension d'alimentation continue $V_{DD}$ et le drain du transistor $T_1$. De plus la grille du transistor $T_2$ est polarisée à travers une résistance $R_{P2}$ par une tension de polarisation positive $V_{G2}$. Eventuellement une capacité $C_2$ relie la grille du transistor de charge $T_2$ au drain du transistor de l'étage isolateur $T_1$. Enfin une capacité de découplage $C_1$ peut être interposée entre le point commun de la grille et de la résistance $R_{P1}$, et le point ST où la branche de contre-réaction est raccordée c'est-à-dire le point où la tension de sortie $V_S$ est prélevée.

Dans un exemple de réalisation, le circuit illustré par la figure 2 est réalisé au moyen des éléments du tableau II. L'impédance de référence pour l'isolateur est $R_0$ = 50 $\Omega$ les transistors $T_1$ de l'isolateur et $T_2$ de la charge sont des MESFETs réalisés au moyen d'arséniure de gallium (GaAs). L'épaisseur du substrat en GaAs sous le circuit isolateur est de 100 μm. La source du transistor $T_1$ est reliée à la masse au moyen d'un trou métallisé qui réalise une impédance selfique de liaison $L_S$ équivalente à une inductance d'environ 0,03 nH. Les autres éléments sont donnés dans le tableau II. Pour le calcul de la longueur de la ligne, on a tenu compte de la relation (9) donnée dans le tableau I où les éléments pour résoudre cette relation sont également donnés.

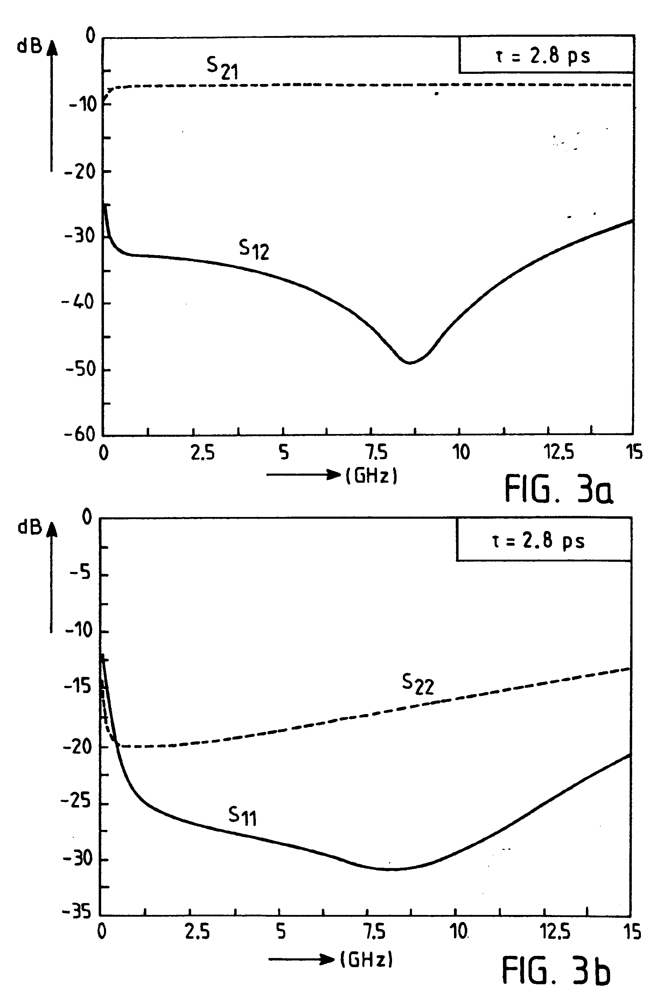

Les performances du circuit sont illustrées par les figures 3 à 5. Les figure 3a et 3b donnent les paramètres S21, S12, S22 et S11 en dB du circuit en fonction de la fréquence en GHz pour un temps de transit τ de 2,8 ps. On peut déduire des courbes que l'isolation est meilleure que 30 dB et l'adaptation meilleure que 20 dB, dans une bande de fonctionnement de 1 à 13 GHz. Ainsi ces performances obtenues sont nettement meilleures que celles du circuit décrit au titre de l'état de la technique.

En outre le circuit selon l'invention est plus compact puisqu'il est réalisé au moyen d'un seul élément réactif. La consommation est plus faible car on n'utilise qu'un transistor qui dans l'exemple de réalisation cité présente une dimension de 100 μm. De plus les performances du circuit ne sont sensibles qu'à la transconductance $g_M$ du transistor, et ce dernier peut être ajusté en agissant sur la polarisation de grille $V_{G1}$ du transistor $T_1$. Ceci permet de compenser les effets des dispersions des caractéristiques du transistor $T_1$ dues à la technologie.

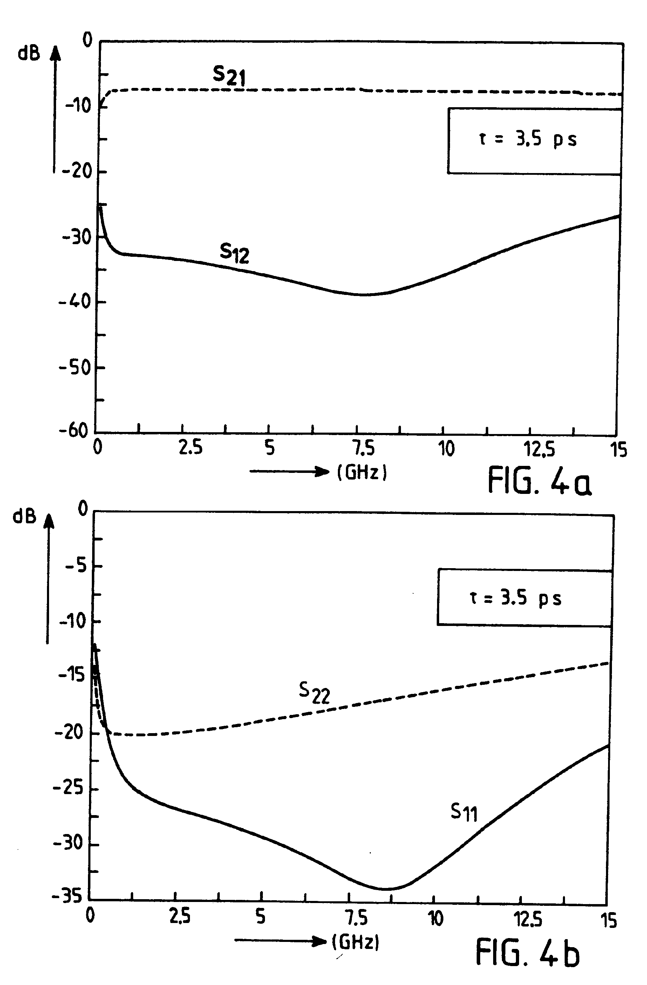

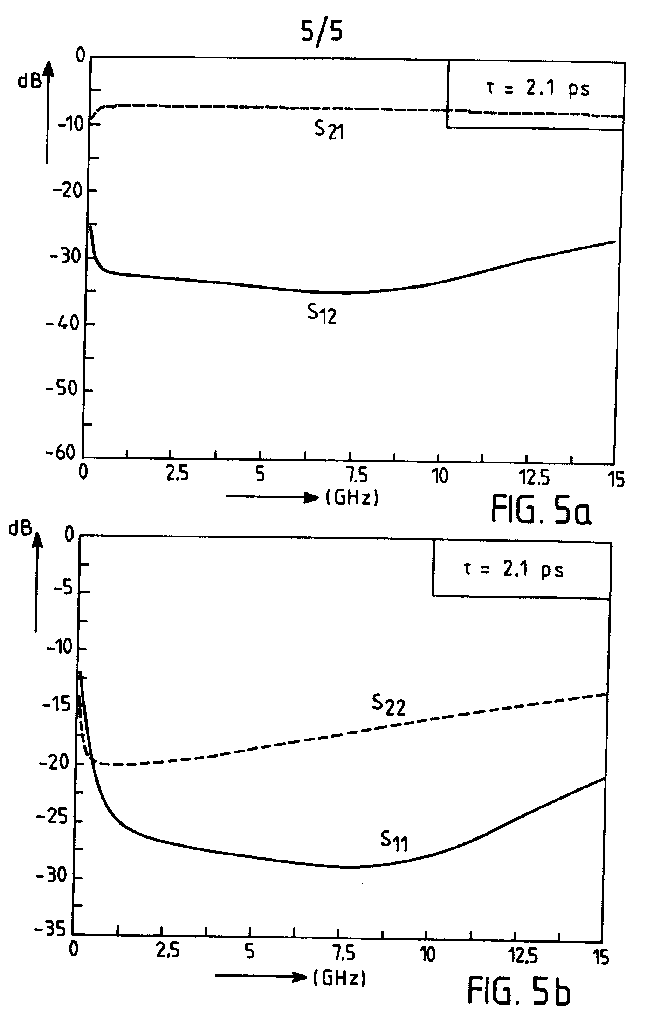

Les figures 4a et 4b donnent ces mêmes paramètres pour un temps de transit τ de 3,5 ps et les figures 5a et 5b donnent ces paramètres pour un temps de transit de 2,1 ps.

Les figures 4 et 5 montrent donc les performances de l'isolateur dans les conditions où le temps de transit des électrons est de 25 % plus grand ou 25 % plus petit par rapport à la valeur initiale des figures 3. On constate que la réponse du circuit est modifiée mais que les performances ne sont pas dégradées ; c'est-à-dire que l'isolation est toujours supérieure à 30 dB et que l'adaptation d'entrée est toujours supérieure à 20 dB dans la bande 1 à 13 GHz.

On notera que la charge active a été choisie pour diminuer les pertes de l'étage et que l'on a constaté d'une façon inattendue que ce montage améliorait l'isolation.

Le circuit selon l'invention est absolument monolithiquement intégrable, très compact et très large bande. Il élimine les problèmes de réflection qui apparaissent dans les circuits hyperfréquence par exemple lorsque des blocs montés en série ne sont pas adaptés ; ou encore lorsque le circuit contient un oscillateur, pour éviter que cet oscillateur bouge en fréquence.

Le circuit selon l'invention ne présente pas un gain en direct extrêmement élevé, mais ceci est un petit inconvénient qui n'est pas un problème du fait que, en circuit intégré hyperfréquences, il est aisé de rajouter un petit amplificateur afin de rattraper ce genre de pertes.

Le circuit selon l'invention peut être également réalisé de façon favorable au moyen de transistors connus de l'homme du métier sous le nom de HEMTs, et d'une façon générale au moyen de tous transistors à effet de champ tels que les transistors connus de l'homme du métier sous le nom de MOSFETs.

## TABLEAU I

$g_m$ = transconductance du transistor $T_1$

$g_F = 1/R_F$  conductance de la résistance de contre-réaction

$g_E = 1/R_E$  conductance de sortie de l'étage précédent

$g_S = 1/R_S$  conductance d'entrée de l'étage suivant

$g_D =$         conductance de drain du transistor $T_1$

$C_{GS}$ = capacité grille-source du transistor $T_1$

$\omega$       = pulsation du signal de fréquence F, d'entrée $V_E$ et
         sortie $V_S$.

Gain de l'isolateur = $V_S/V_E = g_F/(g_F+G_S+j\omega C_{GS})$ (1)

Conductance d'entrée de l'isolateur = $Y_E$

$\quad Y_E = g_F + g_D + g_F(g_m-g_F)/(g_F+g_S+j\omega C_{GS})$ (2)

Isolation = $V_E/V_S = -(g_m-g_F)/(g_F+g_E+g_D)$       (3)

Conductance de sortie de l'isolateur = $Y_S$

$\quad Y_S = j\omega C_{GS} + g_F(g_m+g_D+g_E)/(g_F+g_D+g_E)$ (4)

Longueur de la ligne

$\quad = (R_F/Z_C)v\tau$           (9)

où v est la vitesse de phase

et $\tau = \tau_1 + \tau_2$

avec  $\tau_1$ = temps de transit des électrons sous la grille

$\quad \tau_2 = (R_G + R_{GS}) C_{GS}$

et $Z_C$ = impédance caractéristique de la ligne.

## TABLEAU II

Impédance de référence pour l'isolateur $R_0 = 50\ \Omega$

Transistors $T_1$, $T_2$ = MESFETs réalisés au moyen d'arséniure
de gallium (GaAs), à deux doigts de grille

Longueur de grille des transistors $T_1$, $T_2$     $\ell_G \simeq 0,5\ \mu m$

Largeur de grille des transistors $T_1$, $T_2$     $W_G \simeq 100\ \mu m$

Epaisseur du substrat en GaAs sous le circuit isolateur
$H = 100\ \mu m$

Impédance selfique de liaison de source du transistor
$T_1$ à la masse     $L_S \simeq 0,03\ nH$

Résistances de charge $R_{P1} = R_{P2} = 10\ k\Omega$

Capacité d'isolement en continu     $C_1 = 1pF$

Résistance de la branche de contre-réaction $R_F = 59,4\ \Omega$

Ligne microruban de la branche de contre-réaction $L_F$
de largeur $W_\ell = 10\ \mu m$
de longueur $L_\ell = 458\ \mu m$

Impédance caractéristique de la ligne $Z_\ell = 0,46\ nH (\simeq 0,5nH)$

Tension de polarisation négative $V_{G1} = -0,5\ V$
positive $V_{G2} = 2,5\ V$

Tension d'alimentatioon continue $V_{DD} = 4\ V$

## TABLEAU III

$$g_m = 1/R_F = g_F \quad (5) \qquad 1/R_0 = g_m + g_D \quad (6)$$

Imp. entrée $Z_E = 1/(1/R_F + g_D) \simeq R_F = R_0 \qquad (7)$

Imp. sortie $Z_S = 1/(1/R_F + j\omega C_{GS}) \simeq R_F = R_0 \qquad (8)$

$$\text{Gain de l'isolateur} = V_S/V_E = 1/2 \qquad (1bis)$$

$$\text{Isolation} = V_E/V_S = 0 \qquad (3bis)$$

## Revendications

1. Dispositif semiconducteur intégré incluant un circuit isolateur actif comprenant au moins un transistor à effet de champ, caractérisé en ce que ce dernier comprend un amplificateur à contre-réaction ($T_1$, $R_F$) utilisé dans le sens inverse du sens conventionnel.

2. Dispositif selon la revendication 1, caractérisé en ce que cet amplificateur comprend un étage incluant un transistor à effet de champ, monté en source commune, dont le drain reçoit le signal d'entrée, et dont la grille fournit le signal de sortie, et un circuit de contre-réaction disposé entre la grille et le drain.

3. Dispositif selon la revendication 2, caractérisé en ce que cet étage comprend des moyens pour présenter un gain nul en inverse et une impédance égale à une impédance de référence $R_0$ donnée.

4. Dispositif selon la revendication 3, caractérisé en ce que pour que cet étage présente un gain nul en inverse, la conductance $g_F$ du circuit de contre-réaction et la transconductance $g_M$ du transistor à effet de champ sont choisies égales.

5. Dispositif selon la revendication 4, caractérisé en ce que, pour que cet étage présente une impédance égale à une impédance $R_0$ donnée, les caractéristiques du transistor à effet de champ sont choisies pour que la somme de sa transconductance $g_M$ et de sa conductance de drain $g_D$ égale l'inverse de l'impédance $R_0$ donnée.

6. Dispositif selon la revendication 5, caractérisé en ce que le circuit de contre-réaction est formé d'une branche comprenant une résistance $R_F$.

7. Dispositif selon la revendication 6, caractérisé en ce que pour compenser les retards dus au temps de transit des électrons sous la grille, et aux constantes de temps produites par les résistances d'accès et intrinsèques du transistor et la capacité grille-source, aux fréquences élevées, la branche de contre-réaction comprend aussi une ligne $L_F$ en série avec la résistance $R_F$.

8. Dispositif selon l'une des revendications 4 à 7, caractérisé en ce que pour rendre ajustable la valeur de la transconductance $g_M$ du transistor, et pour compenser les effets des dispersions de ses caractéristiques dues à la technologie, la grille du transistor est munie de moyens de polarisation.

9. Dispositif selon la revendication 8, caractérisé en ce que les moyens de polarisation de grille comprennent une tension de polarisation continue $V_{G1}$ négative appliquée sur la grille à travers une résistance $R_{P1}$.

10. Dispositif selon l'une des revendications 2 à 9, caractérisé en ce que le transistor à effet de champ de l'étage isolateur dit premier transistor est muni d'une charge active appliquée sur son drain.

11. Dispositif selon la revendication 10, caractérisé en ce que la charge active comprend un transistor à effet de champ dit second transistor dont la source est reliée au drain dudit premier transistor, dont le drain est relié à une tension d'alimentation continue $V_{DD}$ et dont la grille est reliée à une tension de polarisation continue positive $V_{G2}$ à travers une résistance $R_{P2}$ et en ce que éventuellement une capacité relie la grille et la source du second transistor.

12. Dispositif selon la revendication 11, caractérisé en ce qu'il est réalisé au moyen d'une technologie mettant en oeuvre des transistors à effet de champ en composé III-V, par exemple des transistors du type dit MESFET ou HEMT.

13. Dispositif selon la revendication 12, caractérisé en ce que le premier et le second transistors sont du type dit MESFET en arséniure de gallium, à deux doigts de grille, de longueur de grille $\ell_G$ équivalente à 0,5 µm, de largeur de grille $W_G$ équivalente à 100 µm.

14. Dispositif selon la revendication 13, caractérisé en ce que la résistance de la branche de contre-réaction, $R_F$ équivalente à 60 Ω, la ligne en série avec cette résistance est une ligne microruban d'impédance caractéristique environ 100 Ω correspondant à une inductance d'environ 0,5 nH.

15. Dispositif selon la revendication 14, caractérisé en ce que la tension de polarisation négative $V_{G1} = -0,5$ V, la tension de polarisation positive $V_{G2} = +2,5$ V, la tension d'alimentation continue $V_{DD} = 4$ V, les résistances de polarisation $R_{P1}$ et $R_{P2}$ sont égales à 10 kΩ.

16. Dispositif selon la revendication 15, caractérisé en ce que une capacité de découplage $C_1$ est disposée entre l'extrémité de la résistance $R_{P1}$ de polarisation de grille et la sortie ST au point où est reliée la branche de contre-réaction.

17. Dispositif selon la revendication 11, caractérisé en ce qu'il est réalisé en une technologie mettant en oeuvre les transistors à effet de champ en silicium du type dit MOSFET.

**Patentansprüche**

1. Integrierte Halbleitervorrichtung mit einer aktiven Isolatorschaltung, die mindestens einen Feldeffekttransistor umfaßt, dadurch gekennzeichnet, daß der letzere einen Gegenkopplungsverstärker ($T_1$, $R_F$) umfaßt, der entgegen der üblichen Richtung eingesetzt wird.

2. Vorrichtung nach Anspruch 1, dadurch gekennzeichnet, daß dieser Verstärker eine Stufe mit einem Feldeffekttransistor, versehen mit einer an Masse gelegten Source, dessen Drain das Eingangssignal empfängt und dessen Gate das Ausgangssignal liefert, und eine zwischen Gate und Drain angeordnete Gegenkopplungsschaltung umfaßt.

3. Vorrichtung nach Anspruch 2, dadurch gekennzeichnet, daß diese Stufe Mittel umfaßt, die eine Verstärkung von Null in umgekehrter Richtung und eine Impedanz gleich einer gegebenen Referenzimpedanz $R_0$ liefern.

4. Vorrichtung nach Anspruch 3, dadurch gekennzeichnet, daß der Wirkleitwert $g_F$ der Gegenkopplungsschaltung und die Steilheit $g_M$ des Feldeffekttransistors gleich groß gewählt werden, damit diese Stufe eine Verstärkung von Null in umgekehrter Richtung liefert.

5. Vorrichtung nach Anspruch 4, dadurch gekennzeichnet, daß die Eigenschaften des Feldeffekttransistors so gewählt werden, daß die Summe seiner Steilheit $g_M$ und seines Drain-Wirkleitwerts $g_D$ gleich dem Kehrwert der gegebenen Impedanz $R_0$ ist, damit diese Stufe eine Impedanz liefert, die gleich einer gegebenen Impedanz $R_0$ ist.

6. Vorrichtung nach Anspruch 5, dadurch gekennzeichnet, daß die Gegenkopplungsschaltung aus einem Zweig mit einem Widerstand $R_F$ gebildet wird.

7. Vorrichtung nach Anspruch 6, dadurch gekennzeichnet, daß der Gegenkopplungszweig auch eine mit dem Widerstand $R_F$ in Reihe geschaltete Leitung $L_F$ umfaßt, um die Verzögerungen zu kompensieren, die aufgrund der Laufzeit der Elektronen im Gate und aufgrund von Zeitkonstanten, die sich aus den Eingangswiderständen und den inneren Widerständen des Transistors ergeben, sowie aufgrund der Gate-Source-Kapazität bei hohen Frequenzen auftreten.

8. Vorrichtung nach einem der Ansprüche 4 bis 7, dadurch gekennzeichnet, daß das Gate des Transistors mit Polarisationsmitteln versehen ist, damit der Wert der Steilheit $g_M$ des Transistors $T_1$ eingestellt und die Streuungseffekte seiner Merkmale aufgrund des Verfahrens kompensiert werden können.

9. Vorrichtung nach Anspruch 8, dadurch gekennzeichnet, daß die Polarisationsmittel eine negative Polarisationsgleichspannung $V_{G1}$ umfassen, die über einen Widerstand $R_{P1}$ an sein Gate angelegt wird.

10. Vorrichtung nach einem der Ansprüche 2 bis 9, dadurch gekennzeichnet, daß der Feldeffekttransistor der Isolatorstufe, als erster Transistor bezeichnet, mit einer an seinen Drain angelegten aktiven Last versehen ist.

11. Vorrichtung nach Anspruch 10, dadurch gekennzeichnet, daß die aktive Last einen Feldeffekttransistor, als zweiter Transistor bezeichnet, umfaßt, dessen Source mit dem Drain des ersten Transistors verbunden ist, dessen Drain mit einer Versorgungsgleichspannungsquelle $V_{DD}$ verbunden ist und dessen Gate mit einer positiven Polarisationsgleichspannung $V_{G2}$ über einen Widerstand $R_{P2}$ verbunden ist, und daß gegebenenfalls eine Kapazität das Gate mit der Source des zweiten Transistors verbindet.

12. Vorrichtung nach Anspruch 11, <u>dadurch gekennzeichnet</u>, daß sie mittels eines Verfahrens unter Verwendung von Feldeffekttransistoren aus der Verbindung III-V, beispielsweise des Typs MESFET oder HEMT, ausgeführt wird.

13. Vorrichtung nach Anspruch 12, <u>dadurch gekennzeichnet,</u> daß der erste und der zweite Transistor vom MESFET-Typ aus Galliumarsenid mit zwei Gateanschlüssen, einer Gatelänge $\ell_G$ von 0,5 µm und einer Gatebreite $W_G$ von 100 µm sind.

14. Vorrichtung nach Anspruch 13, <u>dadurch gekennzeichnet</u>, daß der Widerstand des Gegenkopplungszweigs $R_F$ 60 Ω beträgt und die mit diesem Widerstand in Reihe geschaltete Leitung eine Mikrostreifenleitung mit einem induktiven Scheinwiderstand von etwa 100 Ω, was einer Induktivität von etwa 0,5 nH entspricht, ist.

15. Vorrichtung nach Anspruch 14, <u>dadurch gekennzeichnet</u>, daß die negative Polarisationsspannung $V_{G1}$ - 0,5 V, die positive Polarisationsspannung $V_{G2}$ = +2,5 V, die Versorgungsgleichspannung $V_{DD}$ = 4 V, die Polarisationswiderstände $R_{P1}$ und $R_{P2}$ = 10 kΩ sind.

16. Vorrichtung nach Anspruch 15, <u>dadurch gekennzeichnet</u>, daß eine Entkopplungskapazität $C_1$ zwischen dem Ende des Gate-Polarisationswiderstands $R_{P1}$ und dem Ausgang ST an seinem Anschlußpunkt zum Gegenkopplungszweig angeordnet ist.

17. Vorrichtung nach Anspruch 11, <u>dadurch gekennzeichnet</u>, daß sie mit einem Verfahren unter Verwendung von Feldeffekttransistoren aus Silizium des Typs MOSFET ausgeführt ist.

## Claims

1. Integrated semiconductor device comprising an active isolator circuit that includes at least one field effect transistor, characterized in that the isolator circuit comprises a negative feedback amplifier ($T_1$, $R_F$) used in the reverse sense.

2. Device as claimed in Claim 1, characterized in that this amplifier comprises a stage including a common-source field effect transistor whose drain receives the input signal, and whose gate produces the output signal, and a negative feedback branch connected between the gate and the drain.

3. Device as claimed in Claim 2, characterized in that this stage comprises means for presenting a reverse-sense zero gain and an impedance equal to a given reference impedance $R_0$.

4. Device as claimed in Claim 3, characterized in that the conductance $g_F$ of the negative feedback circuit and the transconductance $g_M$ of the field effect transistor are selected to be equal, so that this stage presents a reverse-sense zero gain.

5. Device as claimed in Claim 4, characterized in that the characteristic features of the field effect transistor are chosen such that the sum of its transconductance $g_M$ and its drain conductance $g_D$ is equal to the inverse value of the given impedance $R_0$, so that this stage presents an impedance equal to a given impedance $R_0$.

6. Device as claimed in Claim 5, characterized in that the negative feedback circuit is constituted by a branch comprising a resistor $R_F$.

7. Device as claimed in Claim 6, wherein, at high frequencies, in order to compensate for the delays owing to the transit times of the electrons under the gate, and owing to the time constants produced by the access and intrinsic resistances of the transistor and gate-source capacitance, the negative feedback branch also includes a line $L_F$ connected in series to the resistor $R_F$.

8. Device as claimed in Claims 4 to 7, wherein in order to render the value of the transconductance $g_M$ of the transistor adjustable, and to compensate for the effects of dispersions of its characteristic features due to the fabrication technique used, the gate of the transistor is provided with bias means.

9. Device as claimed in Claim 8, characterized in that the gate bias means have a negative d.c. bias voltage

$V_{G1}$ applied to the gate through a resistor $R_{P1}$.

10. Device as claimed in one of the Claims 2 to 9, wherein the field effect transistor of the isolator stage termed first transistor has an active load applied to its drain.

11. Device as claimed in Claim 10, wherein the active load comprises a field effect transistor termed second transistor whose source is connected to the drain of said first transistor, whose drain is connected to a d.c. supply voltage $V_{DD}$ and whose gate is connected to a positive d.c. bias voltage $V_{G2}$ through a resistor $R_{P2}$ and wherein optionally a capacitor interconnects the gate and the source of the second transistor.

12. Device as claimed in Claim 11, characterized in that it is fabricated with a technology using compound III-V field effect transistors, for example, transistors of the type commonly referred to as MESFET or HEMT.

13. Device as claimed in Claim 12, characterized in that the first and second transistors are of the type commonly referred to as gallium arsenide MESFET having two gate fingers, the gate length $\ell_G$ being equivalent to 0.5 μm, the gate width $W_G$ being equivalent to 100 μm.

14. Device as claimed in Claim 13, characterized in that the resistance of resistor $R_F$ of the negative feedback branch is equivalent to 60 Q, in that the line connected in series to this resistor is a microstrip line having a characteristic impedance of approximately 100 Q corresponding to an inductive impedance of approximately 0.5 nH.

15. Device as claimed in Claim 14, characterized in that the negative bias voltage $V_{G1}$ is -0.5 V, the positive bias voltage $V_{G2}$ = + 2.5 V, the d.c. supply voltage $V_{DD}$ = 4 V, the bias resistors $R_{P1}$ and $R_{P2}$ are equal to 10 kQ.

16. Device as claimed in Claim 15, characterized in that a decoupling capacitor $C_1$ is inserted between the end of the gate bias resistor $R_{P1}$ and the output ST at the junction of the negative feedback branch.

17. Device as claimed in Claim 11, characterized in that it is realised with technology using the silicon field effect transistors of the type commonly referred to as MOSFET.

FIG. 1a

FIG. 1b

FIG. 2

FIG. 3a

FIG. 3b

13

FIG. 4a

FIG. 4b

FIG. 5a

FIG. 5b